# EUROPEAN PATENT APPLICATION

(11) **EP 4 687 406 A1**
(43) Date of publication of application: **04.02.2026**
(21) Application number: 25190807.5
(22) Date of filing: 21.07.2025
(51) Int. Cl.: H10K 59/122, H10K 59/80

(54) **DISPLAY DEVICE AND ELECTRONIC APPARATUS INCLUDING THE DISPLAY DEVICE**

(30) Priority: 29.07.2024 KR 20240099923
(71) Applicant: Samsung Display Co., Ltd., Yongin-si, Gyeonggi-do (KR)
(72) Inventor: KIM, Hwiseong, Yongin-si (KR); LEE, Jae-Man, Yongin-si (KR); KIM, Sunyoung, Yongin-si (KR); LEE, Maengha, Yongin-si (KR); CHOI, Soojeong, Yongin-si (KR); HA, Seungcheol, Yongin-si (KR)
(74) Representative: Marks & Clerk LLP

(57) **Abstract**

A display device includes: a first substrate divided into an active area and a peripheral area adjacent to the active area, an insulating layer disposed on the first substrate, a pixel defining film disposed on the insulating layer, a light emitting element disposed on the insulating layer, an inorganic layer disposed on the pixel defining film, a second substrate disposed on the inorganic layer, a sealing part disposed between the first substrate and the second substrate and overlapping the peripheral area, and a filling material disposed to fill an inner space defined by the first substrate, the second substrate, and the sealing part. In the peripheral area, the insulating layer may be spaced apart from the filling material with the inorganic layer therebetween.

## Description

### BACKGROUND

The present disclosure herein relates to a display device including a filling material, and an electronic apparatus including the display device.

Various display devices used in multimedia apparatuses, such as televisions, mobile phones, tablet computers, and game consoles, are developed. Two substrates facing each other may be bonded to form a display device, and the display device may include a sealing part which bonds the two substrates to each other, and a filling material filled between the two substrates. The filling material may be formed by providing and curing a liquid composition, and in a case in which the filling material is not sufficiently spread, voids are generated.

### SUMMARY

The present disclosure provides a display device with excellent processibility, and an electronic apparatus including the display device.

An embodiment of the invention provides a display device including a first substrate divided into an active area and a peripheral area adjacent to the active area, an insulating layer overlapping the active area and the peripheral area and disposed on the first substrate, a pixel defining film which overlaps the active area and the peripheral area and is disposed on the insulating layer and in which a pixel opening is defined, a light emitting element disposed on the insulating layer and including a first electrode exposed through the pixel opening, a second electrode disposed on the first electrode, and an emission layer disposed between the first electrode and the second electrode, an inorganic layer disposed on the pixel defining film, a second substrate disposed on the inorganic layer, a sealing part disposed between the first substrate and the second substrate and overlapping the peripheral area, and a filling material disposed to fill an inner space defined by the first substrate, the second substrate, and the sealing part. In the peripheral area, the inorganic layer is disposed between the insulating layer and the filling material.

In an embodiment, the inorganic layer may include indium gallium oxide (IGO), indium zinc oxide (IZO), or indium gallium zinc oxide (IGZO).

In an embodiment, in the peripheral area, the inorganic layer may be directly disposed between the pixel defining film and the filling material.

In an embodiment, the inorganic layer may not overlap the emission layer in a plan view.

In an embodiment, the insulating layer may include an organic material.

In an embodiment, the filling material may include a thermosetting material.

In an embodiment, in the peripheral area, the pixel defining film may be spaced apart from the filling material with the inorganic layer therebetween.

In an embodiment, the pixel opening may be provided in plurality to include a first pixel opening and a second pixel opening. In the active area, the first electrode may be exposed through the first pixel opening, and, in the peripheral area, one surface of the insulating layer may be exposed through the second pixel opening. The inorganic layer may be disposed on the one surface of the insulating layer.

In an embodiment, the inorganic layer may be directly disposed on the one surface of the insulating layer.

In an embodiment, the inorganic layer may be disposed on an inner surface of the pixel defining film which defines the second pixel opening.

In an embodiment, the display device may further include a metal layer disposed between the one surface of the insulating layer and the inorganic layer, and the metal layer may include the same material as the first electrode.

In an embodiment, in the active area, a groove convex in a first direction toward the insulating layer may be defined in the pixel defining film, and a tip part which exposes the groove and protrudes in a second direction toward the groove may be defined on the inorganic layer. The second direction may cross the first direction.

In an embodiment, the display device may further include a spacer disposed between the pixel defining film and the inorganic layer in the active area. A sub-groove convex in a first direction toward the pixel defining film may be defined in the spacer, and a tip part which exposes the sub-groove and protrudes in a second direction toward the sub-groove may be defined on the inorganic layer. The second direction may cross the first direction.

In an embodiment of the invention, a display device includes a first substrate divided into an active area and a peripheral area adjacent to the active area, an insulating layer overlapping the active area and the peripheral area and disposed on the first substrate, a pixel defining film which overlaps the active area and the peripheral area and is disposed on the insulating layer and in which a pixel opening is defined, a light emitting element disposed on the insulating layer and including a first electrode exposed through the pixel opening, a second electrode disposed on the first electrode, and an emission layer disposed between the first electrode and the second electrode, an inorganic layer including indium gallium oxide (IGO), indium zinc oxide (IZO), or indium gallium zinc oxide (IGZO), not overlapping the emission layer in a plan view, and disposed on the pixel defining film, a second substrate disposed on the inorganic layer, a sealing part disposed between the first substrate and the second substrate and overlapping the peripheral area, and a filling material disposed to fill an inner space defined by the first substrate, the second substrate, and the sealing part.

In an embodiment, in the peripheral area, the insulating layer may be spaced apart from the filling material with the inorganic layer therebetween.

In an embodiment, in the peripheral area, the pixel defining film may be spaced apart from the filling material with the inorganic layer therebetween.

In an embodiment, the insulating layer may include an organic material.

In an embodiment, the filling material may include a thermosetting material.

In an embodiment, the pixel opening may be provided in plurality to include a first pixel opening and a second pixel opening. In the active area, the first electrode may be exposed through the first pixel opening, and, in the peripheral area, one surface of the insulating layer may be exposed through the second pixel opening. The inorganic layer may be disposed on the one surface of the insulating layer.

In an embodiment, the inorganic layer may be directly disposed on the one surface of the insulating layer.

In an embodiment, the inorganic layer may be disposed on an inner surface of the pixel defining film which defines the second pixel opening.

In an embodiment, the display device may further include a metal layer disposed between the one surface of the insulating layer and the inorganic layer, and the metal layer may include the same material as the first electrode.

In an embodiment of the invention, an electronic apparatus includes a display device in which a module area is defined, and an electronic module disposed to correspond to the module area, the display device including a first substrate divided into an active area and a peripheral area adjacent to the active area, an insulating layer overlapping the active area and the peripheral area and disposed on the first substrate, a pixel defining film which overlaps the active area and the peripheral area and is disposed on the insulating layer and in which a pixel opening is defined, a light emitting element disposed on the insulating layer and including a first electrode exposed through the pixel opening, a second electrode disposed on the first electrode, and an emission layer disposed between the first electrode and the second electrode, an inorganic layer disposed on the pixel defining film, a second substrate disposed on the inorganic layer, a sealing part disposed between the first substrate and the second substrate and overlapping the peripheral area, and a filling material disposed to fill an inner space defined by the first substrate, the second substrate, and the sealing part. In the peripheral area, the inorganic layer is disposed between the insulating layer and the filling material.

In an embodiment, the inorganic layer may include indium gallium oxide (IGO), indium zinc oxide (IZO), or indium gallium zinc oxide (IGZO).

In an embodiment, in the peripheral area, the inorganic layer may be directly disposed between the pixel defining film and the filling material.

In an embodiment, the inorganic layer may not overlap the emission layer in a plan view.

In an embodiment, the insulating layer may include an organic material, and the filling material may include a thermosetting material.

At least some of the above and other features of the invention are set out in the claims.

### BRIEF DESCRIPTION OF THE FIGURES

The accompanying drawings are included to provide a further understanding of the invention, and are incorporated in and constitute a part of this specification. The drawings illustrate embodiments of the invention and, together with the description, serve to explain principles of the invention. In the drawings:
FIG. 1 is a perspective view illustrating an electronic apparatus according to an embodiment;
FIG. 2 is an exploded perspective view illustrating an electronic apparatus according to an embodiment;
FIG. 3 is a cross-sectional view illustrating a portion corresponding to line I-I' in FIG. 2;
FIG. 4 is a plan view illustrating a portion of a display device according to an embodiment;
FIG. 5 is an enlarged cross-sectional view illustrating area AA' in FIG. 3;
FIG. 6 is an enlarged cross-sectional view illustrating area XX' in FIG. 3;
FIG. 7 is a cross-sectional view illustrating area XX' according to another embodiment;
FIG. 8 is a cross-sectional view illustrating area XX' according to another embodiment;
FIG. 9 is a cross-sectional view illustrating a portion of a display device according to an embodiment; and
FIG. 10 is a cross-sectional view illustrating a portion of a display device according to an embodiment.

### DETAILED DESCRIPTION

The present invention may be modified in various forms, and particular embodiments thereof will be illustrated in the drawings and described herein in detail. The invention should not be construed as limited to the embodiments set forth herein. Rather, these embodiments are provided so that this disclosure will be thorough and complete, and will fully convey the scope of the invention to those skilled in the art.

In the present disclosure, it will be understood that when an element (or region, layer, section, etc.) is referred to as being "on", "connected to" or "coupled to" another element, it can be disposed directly on, connected or coupled to the other element or a third element may be disposed between the elements.

Like reference numbers or symbols refer to like elements throughout. In addition, in the drawings, the thickness, the ratio, and the dimension of elements are exaggerated for effective description of the technical contents. The term "and/or" includes one or more combinations which may be defined by relevant elements. "Or" means "and/or."

It will be understood that, although the terms "first", "second", etc. may be used herein to describe various elements, these elements should not be limited by these terms. These terms are only used to distinguish one element from another element. For example, a first element could be termed a second element without departing from the teachings of the present invention, and similarly, a second element could be termed a first element. As used herein, the singular forms are intended to include the plural forms as well, unless the context clearly indicates otherwise.

In addition, the terms, such as "below", "beneath", "on" and "above", are used for explaining the relation of elements shown in the drawings. The terms are relative concepts and are explained based on the direction shown in the drawing.

It will be further understood that the terms such as "includes" or "has", when used herein, specify the presence of stated features, numerals, steps, operations, elements, parts, or the combination thereof, but do not preclude the presence or addition of one or more other features, numerals, steps, operations, elements, parts, or the combination thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Throughout the disclosure, the expression "at least one of a, b or c" indicates only a, only b, only c, both a and b, both a and c, both b and c, all of a, b, and c, or variations thereof. Hereinafter, an embodiment of the invention will be described with reference to the accompanying drawings.

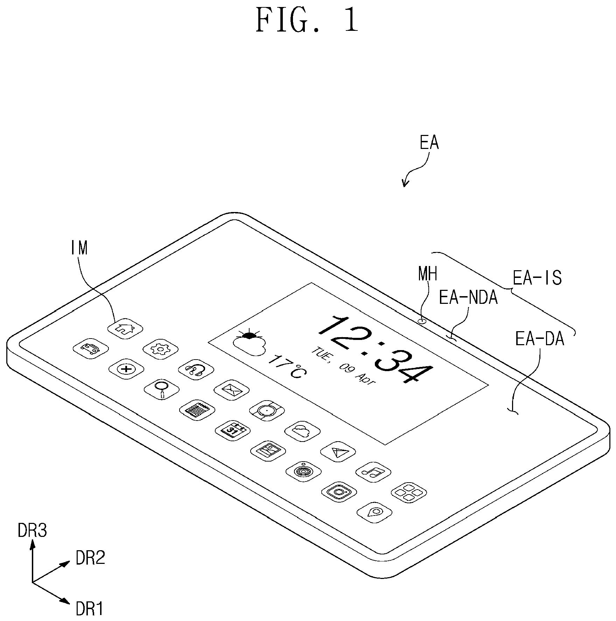

FIG. 1 is a perspective view illustrating an electronic apparatus EA according to an embodiment.

Referring to FIG. 1, the electronic apparatus EA according to an embodiment may be an apparatus that is activated in response to an electrical signal. For example, the electronic apparatus EA may be a medium- and large-sized apparatus such as a television, a monitor, an outdoor billboard, a tablet computer, or a vehicle navigation unit. Alternatively, the electronic apparatus EA may be a small- and medium-sized apparatus such as a personal computer, a notebook computer, a personal digital assistant, a game console, a smartphone, or a camera. These are just provided as examples, and the electronic apparatus EA according to an embodiment may also be employed as other electronic apparatuses unless departing from the invention.

The electronic apparatus EA may display an image IM through a display surface EA-IS. The image IM may include not only a dynamic image but also a still image. The display surface EA-IS may be parallel to a plane defined by a first directional axis DR1 and a second directional axis DR2. FIG. 1 illustrates the electronic apparatus EA provided with the display surface EA-IS that is a flat display surface, but an embodiment is not limited thereto. For another example, the electronic apparatus EA may include a curved display surface or a three-dimensional display surface. The three-dimensional display surface may include a plurality of display areas oriented in different directions.

The display surface EA-IS may include a display area EA-DA, a non-display area EA-NDA, and a sub-area MH. The electronic apparatus EA may display the image IM through the display area EA-DA.

The non-display area EA-NDA may have a predetermined color. The non-display area EA-NDA may be adjacent to the display area EA-DA. The non-display area EA-NDA may surround the display area EA-DA. Accordingly, a shape of the display area EA-DA may be substantially defined by the non-display area EA-NDA. However, FIG. 1 is illustrative, and the non-display area EA-NDA may be disposed adjacent to only one side of the display area EA-DA or may be omitted.

The sub-area MH may detect an external subject received through the display surface EA-IS, or provide the outside with a sound signal such as voice, through the display surface EA-IS. A light signal such as visible light or infrared light may be moved to the sub-area MH.

The sub-area MH may be disposed within the display area EA-DA. However, this is illustrative, and an arrangement of the sub-area MH is not limited to any one embodiment. For another example, the sub-area MH may be surrounded by the non-display area EA-NDA or surrounded by the display area EA-DA and the non-display area EA-NDA. FIG. 1 and the like illustrate one sub-area MH, but the sub-area MH may be provided in plurality.

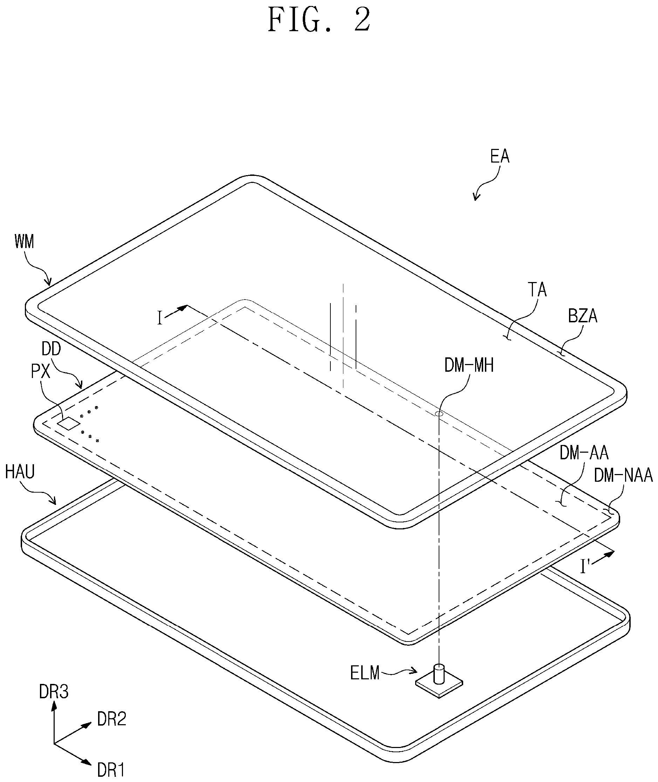

Various electronic modules ELM (see FIG. 2) may be disposed so as to correspond to the sub-area MH. For example, the electronic modules (see FIG. 2) may include at least one of a camera, a speaker, a light detecting sensor, or a heat detecting sensor. The electronic apparatus EA may include the electronic modules (see FIG. 2), each of which photographs an external image using visible light passing through the sub-area MH or determines approach of an external object using infrared light. The electronic module (see FIG. 2) may include a plurality of components, and is not limited to any one embodiment.

FIG. 1 and the following drawings illustrate first to third directional axes DR1, DR2 and DR3, and directions indicated by the first to third directional axes DR1, DR2 and DR3 used herein are relative concepts and may be changed to other directions. In addition, the directions indicated by the first to third directional axes DR1, DR2 and DR3 may be referred to as first to third directions, and may be designated by like reference numbers or symbols. In the present disclosure, the first directional axis DR1 and the second directional axis DR2 perpendicularly cross each other, and the third directional axis DR3 may be a normal direction to a plane defined by the first directional axis DR1 and the second directional axis DR2.

A thickness direction of the electronic apparatus EA may be a direction parallel to the third directional axis DR3 and may be designated by the same/similar reference number or symbol as/to the third directional axis DR3. An upper side (or top or front surface) and a lower side (or bottom or rear surface) may be defined based on the third directional axis DR3. The upper side (or top or front surface) indicates a direction (or surface) that is toward the display surface EA-IS, and the lower side (or bottom or rear surface) indicates a direction (or surface) that is away from the display surface EA-IS. A cross-section indicates a surface parallel to the thickness direction DR3, and a plane indicates a surface perpendicular to the thickness direction DR3. The plane means a plane defined by the first directional axis DR1 and the second directional axis DR2.

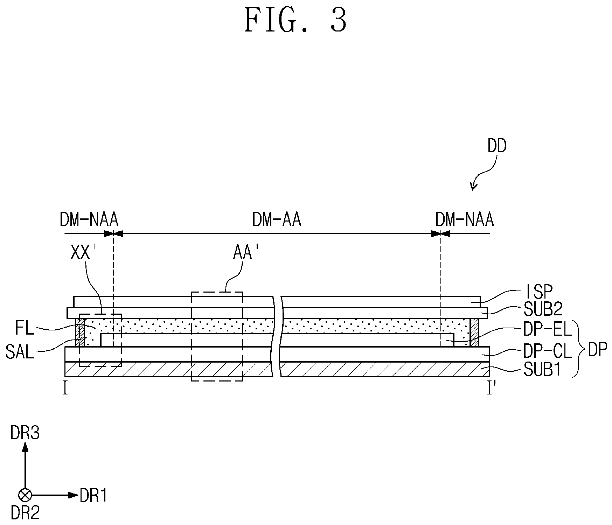

In the present disclosure, when a component overlaps another component, it means that the components overlap each other in a plan view. In the present disclosure, the "plan view" is a view in a thickness direction (i.e., the third direction DR3) of the display device DD (specifically, the first substrate SUB1, See FIGS. 3, 5 and 6). In addition, when a component overlaps another component in a plan view, it is not limited to a case in which the component and the other component have the same shape and the same surface area, and includes a case in which the component and the other component have different shapes and/or different surface areas.

In the present disclosure, when one component is referred to as being directly disposed/provided on another component, it means that a third component is not disposed between the one component and the other component. That is, when one component is referred to as being "directly disposed/provided" on another component, it means that the one component and the other component are in "contact" with each other.

FIG. 2 is an enlarged perspective view illustrating an electronic apparatus EA according to an embodiment. The electronic apparatus EA may include an electronic module ELM, a display device DD, and a window member WM disposed on the display device DD. In addition, the electronic apparatus EA may further include a housing HAU.

The window member WM may cover the entirety of an outer side of the electronic apparatus EA. The window member WM may include a transmission area TA and a bezel area BZA. A front surface of the window member WM including the transmission area TA and the bezel area BZA may correspond to a front surface of the electronic apparatus EA. The transmission area TA may correspond to the display area EA-DA of the electronic apparatus EA illustrated in FIG. 1, and the bezel area BZA may correspond to the non-display area EA-NDA of the electronic apparatus EA illustrated in FIG. 1.

The transmission area TA may be an optically transparent area. The bezel area BZA may be an area having a relatively low light transmittance when compared to the transmission area TA. The bezel area BZA may have a predetermined color. The bezel area BZA may be adjacent to the transmission area TA and surround the transmission area TA. The bezel area BZA may define a shape of the transmission area TA. However, an embodiment is not limited to the illustrated embodiment. For another example, the bezel area BZA may be disposed adjacent to only one side of the transmission area TA, or a portion thereof may be omitted.

The housing HAU may include a material having relatively high rigidity. For examples, the housing HAU may include a frame and/or a plate made of glass, plastic, or metal. The frame and/or the plate may be provided in plurality. The housing HAU may provide a predetermined accommodation space. The display device DD may be accommodated in the accommodation space and protected from an external impact.

The display device DD may be a component that generates an image and detects an external input applied from the outside. An active area DM-AA, a peripheral area DM-NAA, and a module area DM-MH may be defined in the display device DD. The active area DM-AA may overlap the display area EA-DA illustrated in FIG. 1, and the peripheral area DM-NAA may overlap the non-display area EA-NDA illustrated in FIG. 1. The module area DM-MH may overlap the sub-area MH illustrated in FIG. 1.

The active area DM-AA may be an area that is activated in response to an electrical signal. The peripheral area DM-NAA may be an area that is disposed adjacent to at least one side of the active area DM-AA. The peripheral area DM-NAA may be disposed to surround the active area DM-AA. However, an embodiment is not limited thereto, and unlike the illustrated embodiment, a portion of the peripheral area DM-NAA may be omitted. A driving circuit, a driving line, or the like for driving the active area DM-AA may be disposed in the peripheral area DM-NAA.

A plurality of pixels PX may be disposed in the active area DM-AA. The plurality of pixels PX may include a red pixel, a green pixel, and a blue pixel, and may further include a white pixel according to an embodiment.

A light signal such as visible light or infrared light may be moved to the module area DM-MH. The module area DM-MH may be disposed within the active area DM-AA. Alternatively, the module area DM-MH may be surrounded by the peripheral area DM-NAA or surrounded by the active area DM-AA and the peripheral area DM-NAA.

The electronic module ELM may be an electronic part that outputs or receives an optical signal. The electronic module ELM may include a camera module and/or a proximity sensor. The camera module may photograph an external image through the module area DM-MH.

FIG. 3 is a cross-sectional view illustrating a portion corresponding to line I-I' in FIG. 2. FIG. 3 may be a cross-sectional view illustrating a display device DD according to an embodiment.

The display device DD may include a display panel DP and an input sensing part ISP disposed on the display panel DP. The display panel DP may be a component that substantially generates an image. In addition, the display device DD may further include a second substrate SUB2, a sealing part SAL, and a filling material FL. The display panel DP may include a first substrate SUB1, a circuit layer DP-CL disposed on the first substrate SUB1, and a display element layer DP-EL disposed on the circuit layer DP-CL.

The first substrate SUB1 is divided into an active area DM-AA and a peripheral area DM-NAA adjacent to the active area DM-AA. The first substrate SUB1 may provide a base surface on which the circuit layer DP-CL is disposed. The first substrate SUB1 may be a glass substrate, a metal substrate, a polymer substrate, or the like. However, an embodiment is not limited thereto, and the first substrate SUB1 may include an inorganic material, an organic material, or a composite material in another embodiment. The first substrate SUB1 may be a rigid substrate. Alternatively, the first substrate SUB1 may be a flexible substrate capable of being bent, folded, rolled, or the like.

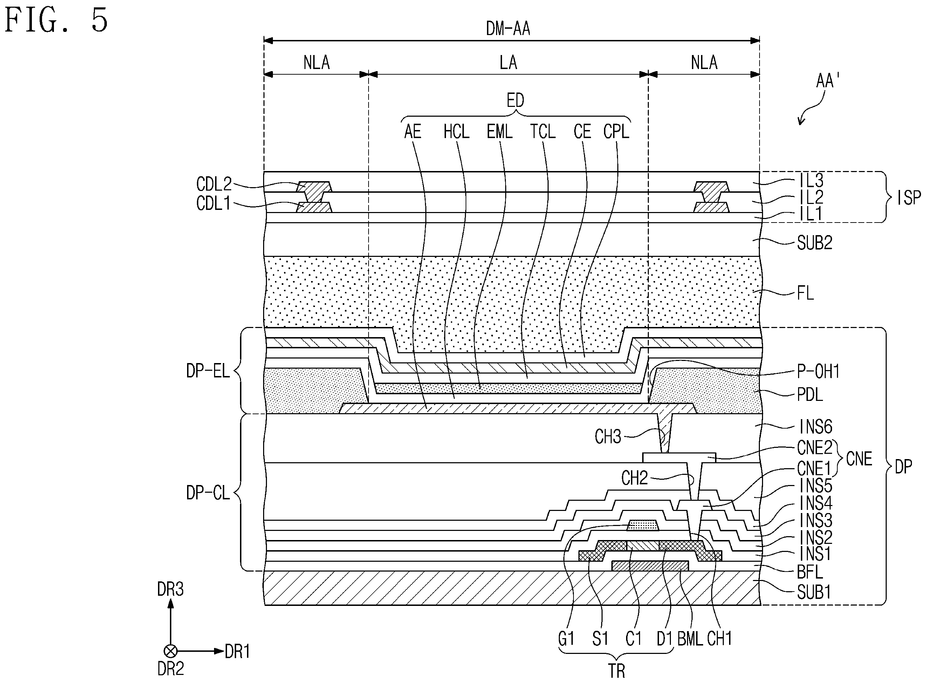

The circuit layer DP-CL may include an insulating layer, a semiconductor pattern, a conductive pattern, a signal line, and/or the like. For example, the circuit layer DP-CL may include a switching transistor and a driving transistor each for driving a light emitting element ED (see FIG. 5) of the display element layer DP-EL.

The display element layer DP-EL may include the light emitting element ED (see FIG. 5) to be described later. For example, the light emitting element ED (see FIG. 5) may include a micro LED, or a nano LED. The light emitting element ED (see FIG. 5) may include an organic light emitting material, an inorganic light emitting material, an organic-inorganic light emitting material, a quantum dot, a quantum rod, or the like.

The input sensing part ISP may sense an external input to covert the external input into a predetermined input signal, and provide the input signal to the display panel DP. For example, in the display device DD according to an embodiment, the input sensing part ISP may be a touch sensing part that senses a touch. The input sensing part ISP may perceive a direct touch by a user, an indirect touch by a user, a direct touch by an object, an indirect touch by an object, or the like.

The input sensing part ISP may sense at least one of a position of a touch applied from the outside, or an intensity (pressure) of the touch. The input sensing part ISP may have various structures or be made of various materials, and is not limited to any one embodiment. For another example, the input sensing part ISP may sense an external input by using a capacitance method. The display panel DP may receive an input signal from the input sensing part ISP, and generate an image corresponding to the input signal.

The second substrate SUB2 may be disposed on a pixel defining film PDL. The second substrate SUB2 may be disposed between the display panel DP and the input sensing part ISP. The second substrate SUB2 may be a glass substrate, a metal substrate, a polymer substrate, or the like. However, an embodiment is not limited thereto, and the second substrate SUB2 may include an inorganic material, an organic material, or a composite material in another embodiment. The second substrate SUB2 may be an encapsulation substrate.

The sealing part SAL and the filling material FL are disposed between the first substrate SUB1 and the second substrate SUB2. The sealing part SAL overlaps the peripheral area DM-NAA. The sealing part SAL may not overlap the active area DM-AA. The sealing part SAL may have a closed loop shape surrounding the active area DM-AA in a plan view. The first substrate SUB1 and the second substrate SUB2 may be bonded to each other through the sealing part SAL. The sealing part SAL may include a thermosetting material or a photocurable material. However, this is illustrative, and an embodiment is not limited thereto.

The filling material FL is disposed to fill an inner spaced defined by the first substrate SUB1, the second substrate SUB2, and the sealing part SAL. Specifically, the filling material FL may be disposed to fill an inner spaced defined by the circuit layer DP-CL disposed on the first substrate SUB1, the second substrate SUB2, and the sealing part SAL. The filling material FL may overlap the active area DM-AA and the peripheral area DM-NAA. The filling material FL may be disposed in a farther inner side of the display device DD than the sealing part SAL is.

The filling material FL may overlap the display element layer DP-EL. In a plan view, a surface area of the filling material FL may be greater than a surface area of the display element layer DP-EL. The display device DD and the electronic apparatus EA (see FIG. 1) each including the filling material FL may exhibit excellent display quality and excellent robustness.

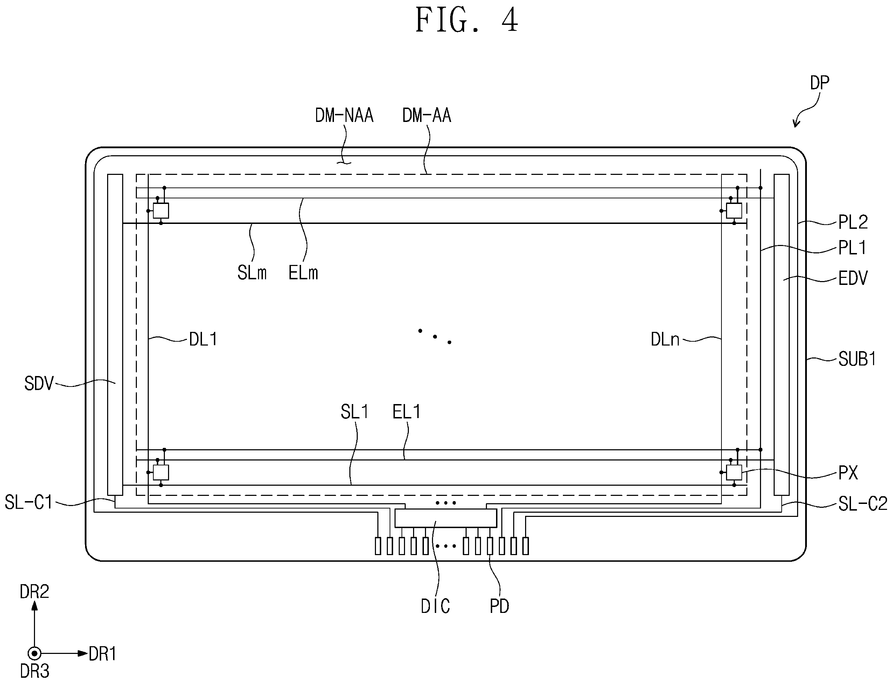

FIG. 4 is a plan view illustrating a display panel DP according to an embodiment. Referring to FIG. 4, the display panel DP may include a plurality of pixels PX, a scan driving circuit SDV, an emission driving circuit EDV, a plurality of signal lines, and a plurality of pads PD. The plurality of pixels PX may be disposed on an active area DM-AA. A driving chip DIC may be mounted on a peripheral area DM-NAA. The driving chip DIC may be disposed on a lower end of the display panel DP. The driving chip DIC may include a data driving circuit. The data driving circuit may be integrated into the display panel DP like the scan driving circuit SDV and the emission driving circuit EDV.

The plurality of signal lines may include a plurality of scan lines SL1 to SLm, a plurality of data lines DL1 to DLn, a plurality of emission lines EL1 to ELm, a first control line SL-C1, a second control line SL-C2, a first power line PL1, and a second power line PL2. Here, m and n are each a natural number of 2 or more.

The scan lines SL1 to SLm may extend in the first direction DR1 to be electrically connected to the pixels PX and the scan driving circuit SDV. The data lines DL1 to DLn may extend in the second direction DR2 to be electrically connected to the pixels PX and the driving chip DIC. The emission lines EL1 to ELm may extend in the first direction DR1 to be electrically connected to the pixels PX and the emission driving circuit EDV.

The first power line PL1 may receive a first power voltage, and the second power line PL2 may receive a second power voltage having a lower level than the first power voltage. The first power line PL1 and the second power line PL2 may be electrically connected to the pads PD, respectively. Although not illustrated, a second electrode CE (see FIG. 5, e.g., a cathode) of the light emitting element ED (see FIG. 5) may be electrically connected to the second power line PL2.

The first control line SL-C1 may be electrically connected to the scan driving circuit SDV, and extend toward the lower end of the display panel DP. The second control line SL-C2 may be electrically connected to the emission driving circuit EDV, and extend toward the lower end of the display panel DP. The pads PD may overlap the peripheral area DM-NAA. The pads PD may be disposed on the peripheral area DM-NAA adjacent to the lower end of the display panel DP, and be more adjacent to the lower end of the display panel DP than the driving chip DIC is. The pads PD may be connected to the driving chip DIC and some of the signal lines.

The scan driving circuit SDV may generate a plurality of scan signals, and the scan signals may be applied to the pixels PX through the scan lines SL1 to SLm. The driving chip DIC may generate a plurality of data voltages, and the data voltages may be applied to the pixels PX through the data lines DL1 to DLn. The emission driving circuit EDV may generate a plurality of emission signals, and the emission signals may be applied to the pixels PX through the emission lines EL1 to ELm. The pixels PX may receive the data voltages in response to the scan signals. The pixels PX may display an image by emitting light with luminance corresponding to the data voltages in response to the emission signals.

FIG. 5 is an enlarged cross-sectional view illustrating area AA' in FIG. 3. FIG. 5 may be a cross-sectional view specifically illustrating an active area DM-AA of a display device DD.

The first substrate SUB1 may include a single layer or a plurality of layers. For example, the first substrate SUB1 may include a first synthetic resin layer, an inorganic substrate having a single-layer or multilayer structure, and a second synthetic resin layer disposed on the inorganic substrate having a single-layer or multilayer structure. Each of the first synthetic resin layer and the second synthetic resin layer may include a polyimide-based resin. Each of the first synthetic resin layer and the second synthetic resin layer may include at least one of acryl-based resin, methacryl-based resin, polyisoprene-based resin, vinyl-based resin, epoxy-based resin, urethane-based resin, cellulose-based resin, siloxane-based resin, polyamide-based resin, or perylene-based resin. The term "α-based" resin used herein indicates one including a functional group of "α".

A display panel DP may include a transistor TR and a light emitting element ED. The transistor TR and the light emitting element ED may be disposed on the first substrate SUB 1. FIG. 5 illustrates one transistor TR, but the display panel DP may substantially include a plurality of transistors and at least one capacitor for driving the light emitting element ED.

A circuit layer DP-CL may include a shielding electrode BML, the transistor TR, a connection electrode CNE, and a plurality of insulating layers BFL and INS1 to INS6. The plurality of insulating layers BFL and INS1 to INS6 may include a buffer layer BFL and first to sixth insulating layers INS1 to INS6. Each of the buffer layer BFL and the first to sixth insulating layers INS1 to INS6 may overlap the active area DM-AA and a peripheral area DM-NAA. However, a stack structure of the circuit layer DP-CL illustrated in FIG. 5 is illustrative, and the stack structure of the circuit layer DP-CL may be changed according to the configuration of the display panel DP, a process of the circuit layer DP-CL, and/or the like.

The shielding electrode BML may be disposed on the first substrate SUB 1. The shielding electrode BML may overlap the transistor TR in a plan view. The shielding electrode BML may protect the transistor TR by blocking light which is incident on the transistor TR from below the display panel DP. The shielding electrode BML may include a conductive material. When a voltage is applied to the shielding electrode BML, a threshold voltage of the transistor TR disposed on the shielding electrode BML may be maintained. However, an embodiment is not limited thereto, and the shielding electrode BML may be a floating electrode in another embodiment. Alternatively, the shielding electrode BML may be omitted.

The buffer layer BFL may be disposed on the first substrate SUB 1 and cover the shielding electrode BML. The buffer layer BFL may include an inorganic material. The buffer layer BFL may include silicon nitride, silicon oxide, or the like. The buffer layer BFL may improve a bonding force between the first substrate SUB 1 and a semiconductor pattern or conductive pattern disposed on the buffer layer BFL.

The transistor TR may include a source S1, a channel C1, a drain D1, and a gate G1. The source S1, the channel C1, and the drain D1 of the transistor TR may be provided from the semiconductor pattern. The semiconductor pattern of the transistor TR may include polysilicon, amorphous silicon, or metal oxide, and as long as having semiconductor properties, the material thereof may be unrestrictedly applied and is not limited to any one material.

The semiconductor pattern may include a plurality of regions divided according to a magnitude of conductivity. A region, which is doped with a dopant or in which a metal oxide is reduced, of the semiconductor pattern may have high conductivity, and may substantially serve as each of a source electrode and a drain electrode of the transistor TR. The region, which has high conductivity, of the semiconductor pattern may correspond to each of the source S1 and the drain D1 of the transistor TR. A region, which has low conductivity by being non-doped or doped at a low concentration or by a metal oxide being non-reduced, of the semiconductor pattern may correspond to the channel C1 (or active) of the transistor TR.

The first insulating layer INS1 may cover the semiconductor pattern of the transistor TR and be disposed on the buffer layer BFL. The gate G1 of the transistor TR may be disposed on the first insulating layer INS1. The gate G1 may overlap the channel C1 of the transistor TR in a plan view. The gate G1 may function as a mask in a process of doping the semiconductor pattern of the transistor TR.

The second insulating layer INS2 may cover the gate G1 and be disposed on the first insulating layer INS1. The third insulating layer INS3 may be disposed on the second insulating layer INS2.

The connection electrode CNE may include a first connection electrode CNE1 and a second connection electrode CNE2 which are provided to electrically connect the transistor TR and the light emitting element ED to each other. However, the components of the connection electrode CNE, which electrically connect the transistor TR and the light emitting element ED to each other, are not limited thereto. For another example, one of the first and second connection electrodes CNE1 and CNE2 may be omitted, or an additional connection electrode may be further included.

The first connection electrode CNE1 may be disposed on the third insulating layer INS3. The first connection electrode CNE1 may be connected to the drain D1 through a first contact hole CH1 passing through the first to third insulating layers INS1 to INS3. The fourth insulating layer INS4 may cover the first connection electrode CNE1 and be disposed on the third insulating layer INS3. The fifth insulating layer INS5 may be disposed on the fourth insulating layer INS4.

The second connection electrode CNE2 may be disposed on the fifth insulating layer INS5. The second connection electrode CNE2 may be connected to the first connection electrode CNE1 through a second contact hole CH2 passing through the fourth and fifth insulating layers INS4 and INS5. The sixth insulating layer INS6 may cover the second connection electrode CNE2 and be disposed on the fifth insulating layer INS5.

Each of the first to fourth insulating layers INS1 to INS4 may be an inorganic insulating layer including an inorganic material. Each of the fifth and sixth insulating layers INS5 and INS6 may be an organic insulating layer including an organic material. For example, the inorganic insulating layer may include at least one of aluminium oxide, titanium oxide, silicon nitride, silicon oxide, silicon oxynitride, zirconium oxide, or hafnium oxide. The organic insulating layer may include at least one of acryl-based resin, methacryl-based resin, polyisoprene-based resin, vinyl-based resin, epoxy-based resin, urethane-based resin, cellulose-based resin, siloxane-based resin, polyamide-based resin, or perylene-based resin.

A display element layer DP-EL may include a pixel defining film PDL and the light emitting element ED. The light emitting element ED may emit light. The light emitting element ED includes a first electrode AE, a second electrode CE disposed on the first electrode AE, and an emission layer EML disposed between the first electrode AE and the second electrode CE. The light emitting element ED may further include a hole control layer HCL disposed between the first electrode AE and the emission layer EML, an electron control layer TCL disposed between the emission layer EML and the second electrode CE, and a capping layer CPL disposed on the second electrode CE. The emission layer EML may not overlap the peripheral area DM-NAA (see FIG. 3).

The first electrode AE may be disposed on the sixth insulating layer INS6. The first electrode AE may be connected to the second connection electrode CNE2 through a third contact hole CH3 passing through the sixth insulating layer INS6. The first electrode AE may be electrically connected to the drain D1 of the transistor TR through the first and second connection electrodes CNE1 and CNE2.

The first electrode AE may be made of a metal material, a metal alloy, or a conductive compound. The first electrode AE may be an anode or a cathode. However, an embodiment is not limited thereto. The first electrode AE may also be a pixel electrode in another embodiment. The first electrode AE may be a transmissive electrode, a semi-transmissive electrode, or a reflective electrode. The first electrode AE may include at least one selected from Ag, Mg, Cu, Al, Pt, Pd, Au, Ni, Nd, Ir, Cr, Li, Ca, LiF, Mo, Ti, W, In, Zn, Sn, and Yb, a compound of two or more selected therefrom, a mixture of two or more selected therefrom, or an oxide thereof.

In a case in which the first electrode AE is a transmissive electrode, the first electrode AE may include a transparent metal oxide, for example, indium tin oxide (ITO), indium zinc oxide ("IZO"), zinc oxide ("ZnO"), indium tin zinc oxide ("ITZO") or the like. In a case in which the first electrode AE is a semi-transmissive electrode or a reflective electrode, the first electrode AE may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, or a compound or mixture thereof (e.g., a mixture of Ag and Mg). Alternatively, the first electrode AE may have a multilayer structure including a reflective film or a semi-transmissive film, each of which is made of the foregoing material, and a transmissive conductive film made of indium tin oxide (ITO), indium zinc oxide (IZO), zinc oxide (ZnO), indium tin zinc oxide (ITZO), or the like. For example, the first electrode AE may have a three-layer structure of ITO/Ag/ITO, but is not limited thereto. However, an embodiment is not limited thereto, and the first electrode AE may include the foregoing metal material, a combination of two or more metal materials selected from the foregoing metal materials, an oxide of the foregoing metal materials, or the like.

The pixel defining film PDL may be disposed on the sixth insulating layer INS6. A first pixel opening P-OH1 which exposes a portion of the first electrode AE is defined in the pixel defining film PDL. The portion of the first electrode AE, which is exposed by the first pixel opening P-OH1, may be defined as a light emitting area LA.

The pixel defining film PDL may include a light blocking material. The light blocking material may include a black pigment and/or a black dye. For example, the pixel defining film PDL may include an organic light blocking material. Alternatively, the pixel defining film PDL may include an inorganic light blocking material.

The active area DM-AA of the display device DD (see FIG. 3) may include the light emitting area LA and a light blocking area NLA. An area in which the pixel defining film PDL is disposed may correspond to the light blocking area NLA. The light blocking area NLA may surround the light emitting area LA within the active area DM-AA.

The hole control layer HCL may be disposed on the first electrode AE and the pixel defining film PDL. The hole control layer HCL may be provided as a common layer overlapping the light emitting area LA and the light blocking area NLA. Unlike the illustrated embodiment, the hole control layer HCL may be provided to overlap the light emitting area LA but not overlap the light blocking area NLA. The hole control layer HCL may include at least one of a hole transport layer, a hole injection layer, or an electron blocking layer. The hole control layer HCL may include a known hole injection material and/or a known hole transport material.

The emission layer EML may be disposed on the hole control layer HCL. The emission layer EML may overlap the active area DM-AA. The emission layer EML may be disposed in the first pixel opening P-OH1. The emission layer EML may overlap the light emitting area LA but not overlap the light blocking area NLA. Unlike the illustrated embodiment, the emission layer EML may be provided as a common layer overlapping the light emitting area LA and the light blocking area NLA. The emission layer EML may include an organic light emitting material and/or an inorganic light emitting material. The emission layer EML may emit light having any one color of red, green, and blue colors.

The electron control layer TCL may be disposed on the emission layer EML. The electron control layer TCL may be provided as a common layer overlapping the light emitting area LA and the light blocking area NLA. Unlike the illustrated embodiment, the electron control layer TCL may be provided to overlap the light emitting area LA but not overlap the light blocking area NLA. The electron control layer TCL may include at least one of an electron transport layer, an electron injection layer, or a hole blocking layer. The electron control layer TCL may include a known electron injection material and/or a known electron transport material.

The second electrode CE may be disposed on the electron control layer TCL. The second electrode CE may be provided as a common layer overlapping the light emitting area LA and the light blocking area NLA. The second electrode CE may be a common electrode. The second electrode CE may be a cathode or an anode, but an embodiment is not limited thereto. For another example, when the first electrode AE is an anode, the second electrode CE may be a cathode, and when the first electrode AE is a cathode, the second electrode CE may be an anode.

The second electrode CE may be a transmissive electrode, a semi-transmissive electrode, or a reflective electrode. In a case in which the second electrode CE is a transmissive electrode, the second electrode CE may be made of a transparent metal oxide, for example, indium tin oxide (ITO), indium zinc oxide (IZO), zinc oxide (ZnO), indium tin zinc oxide (ITZO), or the like.

In a case in which the second electrode CE is a semi-transmissive electrode or a reflective electrode, the second electrode CE may include Ag, Mg, Cu, Al, Pt, Pd, Au, Ni, Nd, Ir, Cr, Li, Ca, LiF/Ca, LiF/Al, Mo, Ti, Yb, W, or a compound or mixture thereof (e.g., AgMg, AgYb or MgYb). Alternatively, the second electrode CE may have a multilayer structure including a reflective film or a semi-transmissive film, each of which is made of the foregoing material, and a transparent conductive film made of indium tin oxide (ITO), indium zinc oxide (IZO), zinc oxide (ZnO), indium tin zinc oxide (ITZO), or the like. For example, the second electrode CE may include the foregoing metal material, a combination of two or more metal materials selected from the foregoing metal materials, an oxide of the foregoing metal materials, or the like.

The capping layer CPL may be disposed on the second electrode CE. The capping layer CPL may be an organic capping layer or an inorganic capping layer. For example, in a case in which the capping layer CPL includes an inorganic material, the inorganic material may include an alkaline metal compound such as LiF, an alkaline earth metal compound such as MgF₂, silicon oxynitride (SiOₓN_{y}), silicon nitride (SiNₓ), silicon oxide (SiO_{y}), or the like. For example, in a case in which the capping layer CPL includes an organic material, the organic material may include α-NPD, NPB, TPD, m-MTDATA, Alq₃, CuPc, N4,N4,N4',N4'-tetra(biphenyl-4-yl) biphenyl-4,4'-diamine (TPD15), 4,4',4"-tris(carbazol-9-yl)triphenylamine (TCTA), or the like, or include epoxy resin, or acrylate such as methacrylate. However, this is illustrative, and the material included in the capping layer CPL is not limited to the foregoing materials.

A filling material FL may be disposed on the display element layer DP-EL. The filling material FL may include a thermosetting material. For example, the filling material FL may include at least one of a silicon-based material, an epoxy-based material, or an acryl-based material. The filling material FL may include at least one of silicon-based resin, epoxy-based resin, or acryl-based resin. A second substrate SUB2 may be disposed on the filling material FL. An input sensing part ISP may be disposed on the second substrate SUB2.

The input sensing part ISP may include a first sensing insulating layer IL1, a second sensing insulating layer IL2, and a third sensing insulating layer IL3. The input sensing part ISP may include at least one conductive layer disposed on the sensing insulating layers. The input sensing part ISP may include a first conductive layer CDL1 and a second conductive layer CDL2.

The first sensing insulating layer IL1 may be disposed on the second substrate SUB2. The first sensing insulating layer IL1 may include at least one inorganic insulating layer. The first sensing insulating layer IL1 may be in contact with the second substrate SUB2. Unlike the illustrated embodiment, the first sensing insulating layer IL1 may be omitted, and in this case, the first conductive layer CDL1 may be in contact with the second substrate SUB2.

The first conductive layer CDL1 may be disposed on the first sensing insulating layer IL1. The first conductive layer CDL1 may include a plurality of first conductive patterns. The plurality of first conductive patterns may be disposed on the first sensing insulating layer IL1. The second sensing insulating layer IL2 may be disposed on the first sensing insulating layer IL1 so as to cover at least a portion of the first conductive layer CDL1.

The second conductive layer CDL2 may be disposed on the second sensing insulating layer IL2. The second conductive layer CDL2 may include a plurality of second conductive patterns. The plurality of second conductive patterns may be disposed on the second sensing insulating layer IL2. The plurality of second conductive patterns may be connected to the plurality of first conductive patterns through contact holes defined in the second sensing insulating layer IL2, respectively.

Each of the plurality of first conductive patterns of the first conductive layer CDL1 and the plurality of second conductive patterns of the second conductive layer CDL2 may be disposed to correspond to the light blocking area NLA. Each of the plurality of first conductive patterns of the first conductive layer CDL1 and the plurality of second conductive patterns of the second conductive layer CDL2 may be a mesh pattern.

The third sensing insulating layer IL3 may be disposed on the second sensing insulating layer IL2, and may cover the second conductive layer CDL2. Each of the second sensing insulating layer IL2 and the third sensing insulating layer IL3 may include an inorganic insulating layer or an organic insulating layer.

Each of the first conductive layer CDL1 and the second conductive layer CDL2 may include a single-layer structure, or include a multilayer structure in which layers are stacked in the third direction DR3. The conductive layers CDL1 and CDL2 each having a single-layer structure may include a conductive metal layer or a transparent conductive layer. The conductive metal layer may include molybdenum, silver, titanium, copper, aluminium, or an alloy thereof. The transparent conductive layer may include a transparent conductive oxide such as indium tin oxide (ITO), indium zinc oxide (IZO), zinc oxide (ZnO), or indium zinc tin oxide (IZTO). The transparent conductive layer may include a conductive polymer such as PEDOT, a metal nanowire, graphene, or the like.

The conductive layers CDL1 and CDL2 each having a multilayer structure may include conductive metal layers. The conductive metal layers may include, for example, a three-layer structure of titanium (Ti)/aluminium (Al)/titanium (Ti). The conductive layers CDL1 and CDL2 each having a multilayer structure may include at least one conductive metal layer and at least one transparent conductive layer.

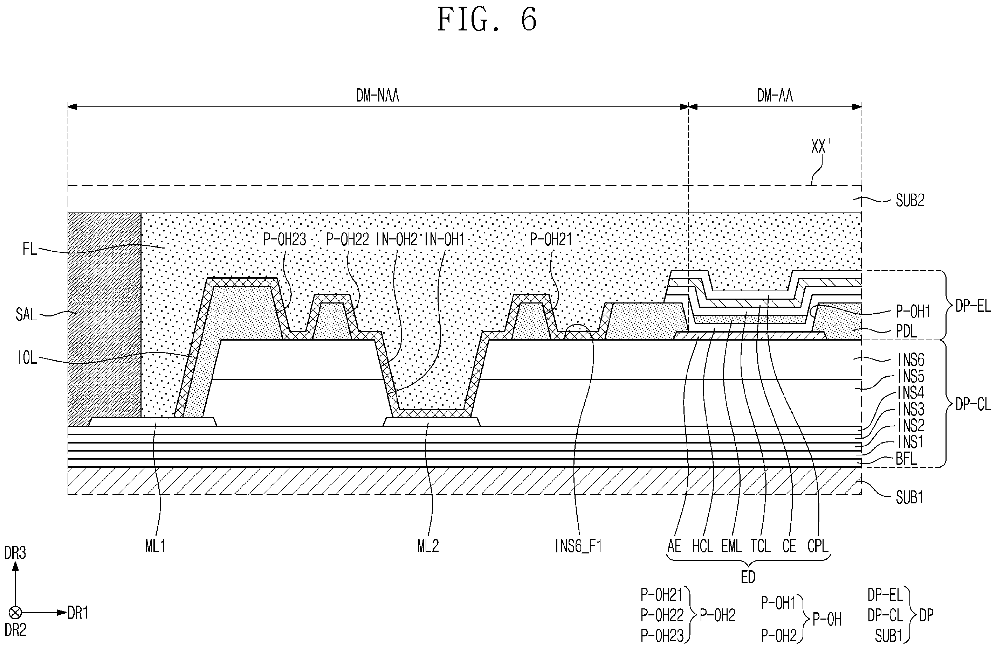

FIG. 6 is an enlarged cross-sectional view illustrating area XX' in FIG. 3. Referring to FIG. 6, the pixel defining film PDL overlaps the active area DM-AA and the peripheral area DM-NAA. In the peripheral area DM-NAA, an inorganic layer IOL may be disposed on the pixel defining film PDL. A second substrate SUB2 may be disposed on the inorganic layer IOL. The inorganic layer IOL may not overlap an emission layer EML in a plan view. In FIG. 6, the inorganic layer IOL is illustrated as not overlapping the active area DM-AA, but an embodiment is not limited thereto. For another example, the inorganic layer IOL may overlap the light blocking area NLA (see FIG. 5) of the active area DM-AA, but not overlap the light emitting area LA (see FIG. 5) of the active area DM-AA.

In the peripheral area DM-NAA, at least a portion of the sixth insulating layer INS6 may be spaced apart from a filling material FL with the inorganic layer IOL therebetween. In the peripheral area DM-NAA, the inorganic layer IOL may be disposed between the at least a portion of the sixth insulating layer INS6 and the filling material FL. In the peripheral area DM-NAA, at least a portion of the pixel defining film PDL may be spaced apart from the filling material FL with the inorganic layer IOL therebetween. In the peripheral area DM-NAA, the inorganic layer IOL may be directly disposed between the least a portion of the pixel defining film PDL and the filling material FL. In the peripheral area DM-NAA, the inorganic layer IOL may be disposed to follow a stepped portion of the pixel defining film PDL and/or the sixth insulating layer INS6.

The inorganic layer IOL may include a metal oxide as an inorganic material. The inorganic layer IOL may include indium gallium oxide (IGO), indium zinc oxide (IZO), or indium gallium zinc oxide (IGZO). The inorganic layer IOL may be disposed between a component including an organic material and the filling material FL, and prevent (or minimize) contact between the component including the organic material and the filling material FL. For example, the component including the organic material may be the sixth insulating layer INS6 and/or the pixel defining film PDL. The sixth insulating layer INS6 may be an insulating layer disposed uppermost in a circuit layer DP-CL and including an organic material. The sixth insulating layer INS6 may be an insulating layer the most adjacent to a display element layer DP-EL among the insulating layers of the circuit layer DP-CL, and including an organic material.

A process of manufacturing a display device includes a process performed at a low temperature (hereinafter referred to as a low-temperature process) and a process performed at a high temperature (hereinafter referred to as a high-temperature process). A filling material is formed by providing a liquid thermosetting material, and is cured by heat and then undergoes a cooling process. During the cooling process, a portion of the filling material is contracted to form a void. The portion is present in an area, which is adjacent to a sealing part, of the peripheral area, and the filling material is not present in a portion in which the void is formed. As the cooling process is followed by the low-temperature process and the high-temperature process according to the manufacture process, expansion and contraction of the void are repeated to generate a defect. In the area, which is adjacent to the sealing part, of the peripheral area, in a case in which a component including an organic material and the filling material are in contact with each other, the void is further expanded. The component (e.g., the sixth insulating layer and/or the pixel defining film) including an organic material exhibits relatively low adhesion to the filling material, and thus does not prevent the expansion and contraction of the void. Thus, a display device having the generated void shows decreased processibility.

On the other hand, the display device DD (see FIG. 2) according to an embodiment may include, in the peripheral area DM-NAA, the inorganic layer IOL disposed between the filling material FL and the component (e.g., the sixth insulating layer INS6 and/or the pixel defining film PDL) including an organic material, and thus, instead of the component including an organic material, the inorganic layer IOL may be in contact with the filling material FL. The inorganic layer IOL may exhibit relatively high adhesion to the filling material FL. Accordingly, the display device DD (see FIG. 2) according to an embodiment may effectively prevent (or minimize) the formation and the expansion of the void, and exhibit the excellent processibility. For the same reason, the electronic apparatus EA (see FIG. 2) including the display device DD (see FIG. 2) according to an embodiment may exhibit the excellent processibility.

A pixel opening P-OH is defined in the pixel defining film PDL, and the pixel opening P-OH may be provided in plurality. The plurality of pixel openings P-OH may include a first pixel opening P-OH1 and a second pixel opening P-OH2. The first pixel opening P-OH1 and the second pixel opening P-OH2 may be spaced apart from each other in the first direction DR1 perpendicular to the thickness direction DR3. The first pixel opening P-OH1 may overlap the active area DM-AA, and a first electrode AE may be exposed through the first pixel opening P-OH1 as described above. The inorganic layer IOL may not be disposed on an inner surface of the pixel defining film PDL which defines the first pixel opening P-OH1.

The second pixel opening P-OH2 may overlap the peripheral area DM-NAA. One surface INS6_F1 of the sixth insulating layer INS6 may be exposed through the second pixel opening P-OH2. In the sixth insulating layer INS6, the one surface INS6_F1 may be a top surface. The top surface of the sixth insulating layer INS6 may be a surface that is spaced apart from a first substrate SUB 1 and adjacent to the display element layer DP-EL. In the sixth insulating layer INS6, a bottom surface may be a surface that faces the top surface and is spaced apart from the display element layer DP-EL with the top surface therebetween.

The second pixel opening P-OH2 may be provided in plurality. The plurality of second pixel openings P-OH2 may include first to third sub-openings P-OH21, P-OH22 and P-OH23. The first to third sub-openings P-OH21, P-OH22 and P-OH23 may be spaced apart from each other in the first direction DR1 perpendicular to the thickness direction DR3. Among the first to third sub-openings P-OH21, P-OH22 and P-OH23, the first sub-opening P-OH21 may be the most adjacent to the active area DM-AA, and the third sub-opening P-OH23 may be the farthest away from the active area DM-AA. The second sub-opening P-OH22 may overlap first and second openings IN-OH1 and IN-OH2 in a plan view to be described later, and one surface of a fourth insulating layer INS4 may be exposed through the second sub-opening P-OH22. The one surface INS6_F1 of the sixth insulating layer INS6 may be exposed through the first and third sub-openings P-OH21 and P-OH23.

The inorganic layer IOL may be disposed on the one surface INS6_F1 of the sixth insulating layer INS6 exposed through the first and third sub-openings P-OH21 and P-OH23. The inorganic layer IOL may be directly disposed on the one surface INS6_F1 of the sixth insulating layer INS6. The inorganic layer IOL may be disposed between the filling material FL and the one surface INS6_F1 of the sixth insulating layer INS6 exposed through the first and third sub-openings P-OH21 and P-OH23. The inorganic layer IOL may be directly disposed between the filling material FL and the one surface INS6_F1 of the sixth insulating layer INS6. The inorganic layer IOL may be disposed on an inner surface of the pixel defining film PDL which defines the first to third sub-openings P-OH21, P-OH22 and P-OH23. The inorganic layer IOL may be disposed on the inner surface of the pixel defining film PDL which defines the second pixel opening P-OH2.

Although FIG. 6 illustrates the inorganic layer IOL that is not disposed on a portion of the pixel defining film PDL adjacent to the active area DM-AA, an embodiment is not limited thereto. For another example, the inorganic layer IOL may be disposed on the portion of the pixel defining film PDL adjacent to the active area DM-AA, and be in contact with a hole control layer HCL or the like in the first direction DR1 perpendicular to the thickness direction DR3.

The first opening IN-OH1 may be defined in the fifth insulating layer INS5. The second opening IN-OH2 may be defined in the sixth insulating layer INS6. The first opening IN-OH1 and the second opening IN-OH2 may overlap each other in a plan view. Each of the first opening IN-OH1 and the second opening IN-OH2 may overlap the second sub-opening P-OH22 in a plan view. In the first direction DR1 perpendicular to the thickness direction DR3, a width of each of the first opening IN-OH1 and the second opening IN-OH2 may be less than a width of the second sub-opening P-OH22. The inorganic layer IOL may be disposed on an inner surface of the fifth insulating layer INS5 which defines the first opening IN-OH1. The inorganic layer IOL may be disposed on an inner surface of the sixth insulating layer INS6 which defines the second opening IN-OH2.

The one surface of the fourth insulating layer INS4 may be exposed through the first and second openings IN-OH1 and IN-OH2. A second metal pattern ML2 may be disposed on the one surface of the fourth insulating layer INS4 exposed through the first and second openings IN-OH1 and IN-OH2. The second metal pattern ML2 may include a metal or an alloy. The second metal pattern ML2 may be a semiconductor pattern, a conductive pattern, or a signal line. Alternatively, the second metal pattern ML2 may be in a floated state. The inorganic layer IOL may be disposed on the second metal pattern ML2. The inorganic layer IOL may be directly disposed on the second metal pattern ML2.

In an area adjacent to a sealing part SAL, a first metal pattern ML1 may be disposed on the one surface of the fourth insulating layer INS4. The first metal pattern ML1 and the second metal pattern ML2 may be spaced apart from each other in the first direction DR1 perpendicular to the thickness direction DR3. The sealing part SAL may be disposed on the first metal pattern ML1. The first metal pattern ML1 may be a floating pattern. The first metal pattern ML1 may include a metal or an alloy. The first metal pattern ML1 including a metal or an alloy may increase transfer efficiency of heat provided to the sealing part SAL in a process of curing the sealing part SAL. Accordingly, a curing rate of the sealing part SAL may be improved.

Disposed positions of the first and second metal patterns ML1 and ML2 illustrated in FIG. 6 are provided as an example. For example, according to a process for the circuit layer DP-CL, the disposed position of at least one of the first metal pattern ML1 or the second metal pattern ML2 may be changed, or at least one of the first metal pattern ML1 or the second metal pattern ML2 may be omitted.

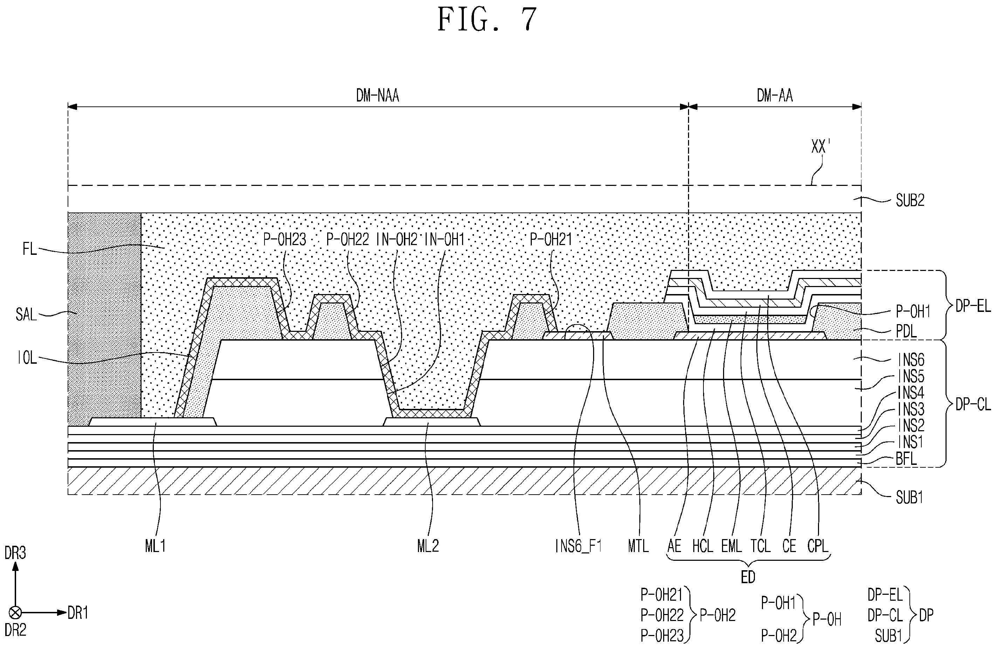

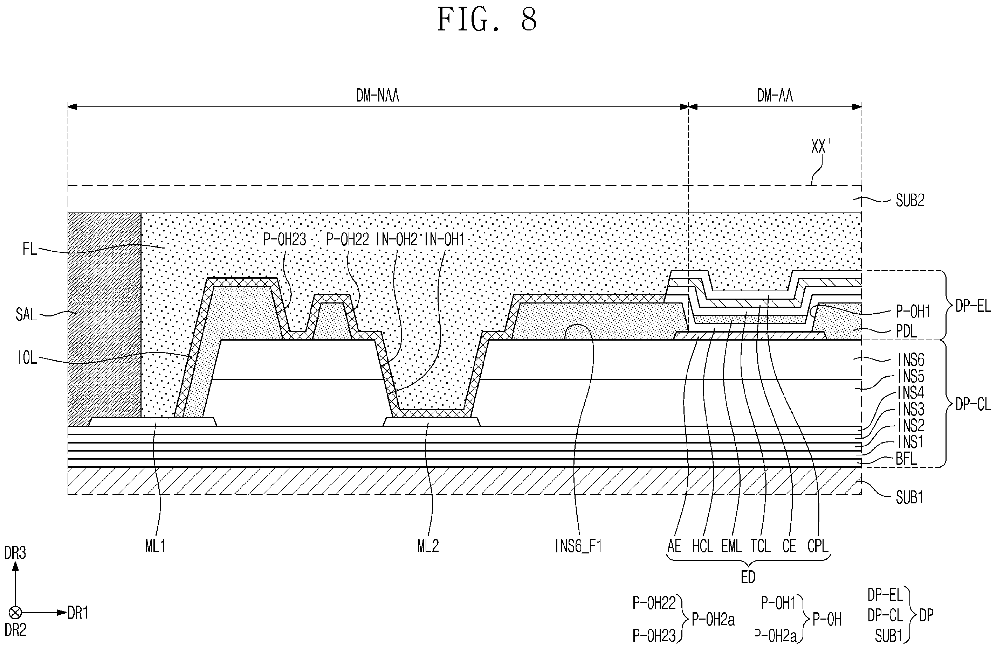

FIGS. 7 and 8 are cross-sectional views illustrating area XX' according to an embodiment of the invention. Hereinafter, embodiments will be described with reference to FIGS. 7 and 8 by avoiding the contents in common with the contents described with reference to FIGS. 1 to 6, and mainly in terms of differences.

FIG. 7 differs from FIG. 6 in that a metal layer MTL is disposed on one surface INS6_F1 of a sixth insulating layer INS6. Specifically, the metal layer MTL may be disposed on the one surface INS6_F1 of the sixth insulating layer INS6 exposed through a first sub-opening P-OH21. The metal layer MTL may be disposed between a filling material FL and the one surface INS6_F1 of the sixth insulating layer INS6 exposed through the first sub-opening P-OH21. The metal layer MTL may be directly disposed between the filling material FL and the one surface INS6_F1 of the sixth insulating layer INS6 exposed through the first sub-opening P-OH21.

The metal layer MTL may be directly disposed on the one surface INS6_F1 of the sixth insulating layer INS6 exposed through the first sub-opening P-OH21. Although not illustrated, the metal layer MTL may be directly disposed on the one surface INS6_F1 of the sixth insulating layer INS6 exposed through a third sub-opening P-OH23.

The metal layer MTL may be made of an inorganic material. The metal layer MTL may be made of the same material as a first electrode AE. The metal layer MTL may be formed in the same step as the first electrode AE. For example, the metal layer MTL may be made of an inorganic material such as a metal material, a metal alloy, or a conductive compound. The metal layer MTL may include at least one selected from Ag, Mg, Cu, Al, Pt, Pd, Au, Ni, Nd, Ir, Cr, Li, Ca, LiF, Mo, Ti, W, In, Zn, Sn, and Yb, a compound of two or more selected therefrom, a mixture of two or more selected therefrom, or an oxide thereof. As the metal layer MTL is disposed on the one surface INS6_F1 of the sixth insulating layer INS6, contact between the filling material FL and the sixth insulating layer INS6 including an organic material may be prevented.

The metal layer MTL may be disposed between the one surface INS6_F1 of the sixth insulating layer INS6 and an inorganic layer IOL. Accordingly, FIG. 7 illustrates the inorganic layer IOL which is provided on only one area of a top surface of the metal layer MTL but not provided on the remaining area. As the metal layer MTL is disposed on the one surface INS6_F1 of the sixth insulating layer INS6, and the metal layer MTL prevents the contact between the filling material FL and the sixth insulating layer INS6, a formation area of the inorganic layer IOL may be reduced.

FIG. 8 differs from FIG. 6 in that the first sub-opening P-OH21 (see FIG. 6) is omitted. A second pixel opening P-OH2a of a pixel defining film PDL illustrated in FIG. 8 may include second and third sub-openings P-OH22 and P-OH23 but not include the first sub-opening P-OH21 (see FIG. 6).

Referring to FIG. 8, in a peripheral area DM-NAA, an opening (e.g., first sub-opening P-OH21) may not be defined in one area of the pixel defining film PDL. The one area may indicate an area most adjacent to an active area DM-AA. As the opening is not defined, exposure of one surface INS6_F1 of a sixth insulating layer INS6 may be minimized. An inorganic layer IOL may be disposed on the pixel defining film PDL in which the first sub-opening P-OH21 (see FIG. 6) is not defined. A stepped portion of the pixel defining film PDL in which the first sub-opening P-OH21 (see FIG. 6) is not defined may be reduced, and in this case, film formability of the inorganic layer IOL may be improved. The inorganic layer IOL is formed by depositing an inorganic material, and as the first sub-opening P-OH21 (see FIG. 6) is not defined in the pixel defining film PDL, the stepped portion may be reduced, and the inorganic layer IOL may be easily formed.

For example, the inorganic layer IOL disposed on one area of the pixel defining film PDL may extend from the peripheral area DM-NAA toward the active area DM-AA and be contact with a hole control layer HCL. In the peripheral area DM-NAA, the inorganic layer IOL may be disposed between the pixel defining film PDL and a filling material FL. As the inorganic layer IOL has high adhesion to the filling material FL, the display device DD (see FIG. 2) according to an embodiment including the inorganic layer IOL may prevent the formation and the expansion of the void, and exhibit the excellent processibility. For the same reason, the electronic apparatus EA (see FIG. 2) including the display device DD (see FIG. 2) according to an embodiment may exhibit the excellent processibility.

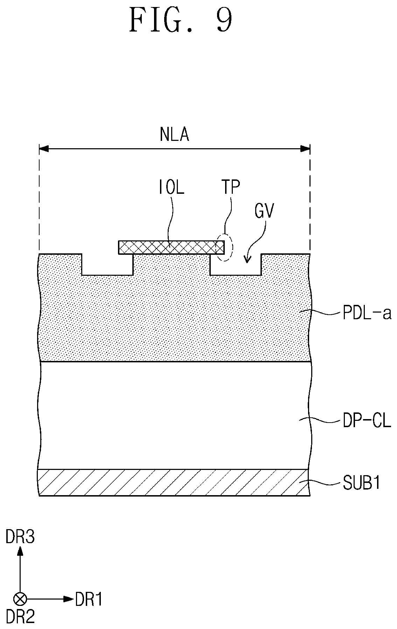

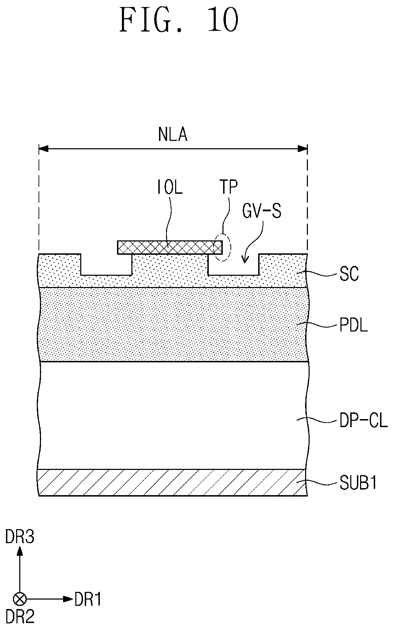

FIGS. 9 and 10 are each a cross-sectional view illustrating a light blocking area NLA according to an embodiment of the invention. For concise explanation, FIGS. 9 and 10 illustrate only some of the components of the display device DD (see FIG. 2). Hereinafter, embodiments will be described with reference to FIGS. 9 and 10 by avoiding the contents in common with the contents described with reference to FIGS. 1 to 8, and mainly in terms of differences.

Referring to FIG. 9, in the light blocking area NLA, a groove GV may be defined in a pixel defining film PDL-a. In the thickness direction DR3, the groove GV may pass through only a portion of the pixel defining film PDL-a. The groove GV may pass through a top surface of the pixel defining film PDL-a but not pass through a bottom surface of the pixel defining film PDL-a. The groove GV may be convex in a direction toward the sixth insulating layer INS6 (see FIG. 5) of a circuit layer DP-CL. The groove GV may have a convex downward shape on a cross-section. Here, the term "downward" may indicate a direction that is away from the display surface EA-IS (see FIG. 1), and be a direction (hereinafter referred to as a fourth direction) opposite to a direction in which the third directional axis DR3 extends.

An inorganic layer IOL may be disposed on the pixel defining film PDL-a in which the groove GV is defined. In the light blocking area NLA, the inorganic layer IOL may be disposed on one area of the pixel defining film PDL-a. In the light blocking area NLA, a surface area of the inorganic layer IOL may be less than a surface area of the pixel defining film PDL-a. Here, the surface area indicates a surface area in a plan view.

A tip part TP which exposes the groove GV and protrudes in a direction toward the groove GV (e.g., a direction parallel to the first direction DR1) may be defined on the inorganic layer IOL. The direction toward the groove GV (e.g., the direction parallel to the first direction DR1) may cross the fourth direction. The tip part TP may protrude outward from an inner surface, which is the most adjacent to the inorganic layer IOL, of inner surfaces of the pixel defining film PDL-a which defines the groove GV.

An emission layer of a light emitting element may be formed using a mask in which a deposition opening is defined. A deposition material may pass through the deposition opening of the mask to form the emission layer on a first electrode. While the mask is provided and/or removed, an impact may be applied to a pixel defining film, and due to this, particles constituting the pixel defining film may be separated to generate a dark dot. In an embodiment, the particles may be prevented (or minimized) from being separated from the pixel defining film PDL-a in which the groove GV is defined, thereby improving display quality. The display device DD (see FIG. 2) including the pixel defining film PDL-a in which the groove GV is defined may exhibit excellent display quality.

Referring to FIG. 10, the display device DD (see FIG. 2) may further include a spacer SC disposed on a pixel defining film PDL. In the light blocking area NLA, the spacer SC may be disposed between the pixel defining film PDL and an inorganic layer IOL. The spacer SC may not overlap the emission layer EML in a plan view (see FIG. 5). The spacer SC may prevent (or minimize) an impact, which is applied due to the mask in which the deposition opening is defined, from being transmitted to the pixel defining film PDL.

A sub-groove GV-S may be defined in the spacer SC. In the thickness direction DR3, the sub-groove GV-S may pass through only a portion of the spacer SC. The sub-groove GV-S may pass through a top surface of the spacer SC but not pass through a bottom surface of the spacer SC. The sub-groove GV-S may be convex in a direction that is toward the pixel defining film PDL. The sub-groove GV-S may have a convex downward shape on a cross-section. Here, the term "downward" may indicate a direction that is away from the display surface EA-IS (see FIG. 2), and be a direction (i.e., the fourth direction) opposite to a direction in which the third directional axis DR3 extends.

In the first direction DR1 perpendicular to the thickness direction DR3, a width of the spacer SC may be substantially the same as the smallest width of the pixel defining film PDL. The phrase "being substantially the same" used herein includes a case of being the same in terms of physical measurements, and a case of having a difference within a margin of a process error.

The inorganic layer IOL may be disposed on the spacer SC in which the sub-groove GV-S is defined. In the light blocking area NLA, the inorganic layer IOL may be disposed on one area of the spacer SC. In the light blocking area NLA, a surface area of the inorganic layer IOL may be less than a surface area of the spacer SC. Here, the surface area indicates a surface area in a plan view.

A tip part TP which exposes the sub-groove GV-S and protrudes in a direction toward the sub-groove GV-S (e.g., a direction parallel to the first direction DR1) may be defined on the inorganic layer IOL. The direction toward the sub-groove GV-S (e.g., the direction parallel to the first direction DR1) may cross the fourth direction. The tip part TP may protrude outward from an inner surface, which is the most adjacent to the inorganic layer IOL, of inner surfaces of the spacer SC which defines the sub-groove GV-S.

An electronic apparatus according to an embodiment includes a display device according to an embodiment. The display device according to an embodiment may include an inorganic layer disposed between a filling material and a component

(e.g., the sixth insulating layer and/or the pixel defining film) including an organic material. The inorganic layer may exhibit relatively high adhesion to the filling material, and effectively prevent generation/expansion of a void due to contraction/expansion of the filling material. Accordingly, the display device according to an embodiment including the inorganic layer may exhibit excellent processibility. For the same reason, the electronic apparatus including the display device according to an embodiment may exhibit excellent processibility.

The display device according to the embodiment and the electronic apparatus including the display device may include the inorganic layer disposed between other component and the filling material, thereby exhibit the excellent processibility.

Although the embodiments of the present invention have been described, it is understood that the present invention should not be limited to these embodiments but various changes and modifications can be made by one ordinary skilled in the art within the scope of the present invention as hereinafter claimed.

Therefore, the technical scope of the invention is not limited to the contents described in the detailed description of the specification, but should be determined by the claims.

## Claims

1. A display device (DD) comprising:
a first substrate (SUB1) divided into an active area (DM-AA) and a peripheral area (DM-NAA) adjacent to the active area (DM-AA);
an insulating layer (INS6) overlapping the active area (DM-AA) and the peripheral area (DM-NAA), and disposed on the first substrate (SUB1);
a pixel defining film (PDL), which overlaps the active area (DM-AA) and the peripheral area (DM-NAA) and is disposed on the insulating layer (INS6), and in which a pixel opening (P-OH) is defined;
a light emitting element (ED) disposed on the insulating layer (INS6) and comprising a first electrode (AE) exposed through the pixel opening (P-OH), a second electrode (CE) disposed on the first electrode (AE), and an emission layer (EML) disposed between the first electrode (AE) and the second electrode (CE);
an inorganic layer (IOL) disposed on the pixel defining film (PDL);
a second substrate (SUB2) disposed on the inorganic layer (IOL);
a sealing part (SAL) disposed between the first substrate (SUB1) and the second substrate (SUB2), and overlapping the peripheral area (DM-NAA); and
a filling material (FL) disposed to fill an inner space defined by the first substrate (SUB1), the second substrate (SUB2), and the sealing part (SAL),
wherein, in the peripheral area (DM-NAA), the inorganic layer (IOL) is disposed between the insulating layer (INS6) and the filling material (FL).

2. The display device (DD) of claim 1, wherein the inorganic layer (IOL) comprises indium gallium oxide (IGO), indium zinc oxide (IZO), or indium gallium zinc oxide (IGZO).

3. The display device (DD) of claim 1 or claim 2, wherein, in the peripheral area (DM-NAA), the inorganic layer (IOL) is directly disposed between the pixel defining film (PDL) and the filling material (FL).

4. The display device (DD) of any one of claims 1 to 3, wherein the inorganic layer (IOL) does not overlap the emission layer (EML) in a plan view.

5. The display device (DD) of any one of claims 1 to 4, wherein the insulating layer (INS6) comprises an organic material.

6. The display device (DD) of any one of claims 1 to 5, wherein the filling material (FL) comprises a thermosetting material.

7. The display device (DD) of any one of claims 1 to 6, wherein, in the peripheral area (DM-NAA), the pixel defining film (PDL) is spaced apart from the filling material (FL) with the inorganic layer (IOL) therebetween.

8. The display device (DD) of any one of claims 1 to 7, wherein the pixel opening (P-OH) is provided in plurality to comprise a first pixel opening (P-OH1) and a second pixel opening (P-OH2),
wherein, in the active area (DM-AA), the first electrode (AE) is exposed through the first pixel opening (P-OH1), and
in the peripheral area (DM-NAA), one surface (INS6_F1) of the insulating layer (INS6) is exposed through the second pixel opening (P-OH2),
wherein the inorganic layer (IOL) is disposed on the one surface (INS6 _F1) of the insulating layer (INS6).

9. The display device (DD) of claim 8, wherein the inorganic layer (IOL) is directly disposed on the one surface (INS6 _F1) of the insulating layer (INS6).

10. The display device (DD) of claim 8 or claim 9, wherein the inorganic layer (IOL) is disposed on an inner surface of the pixel defining film (PDL) which defines the second pixel opening (P-OH2).

11. The display device (DD) of claim 8, further comprising a metal layer (MTL) disposed between the one surface (INS6 _F1) of the insulating layer (INS6) and the inorganic layer (IOL),
wherein the metal layer (MTL) comprises a same material as the first electrode (AE).

12. The display device (DD) of any one of claims 1 to 11, wherein, in the active area (DM-AA), a groove (GV) convex in a first direction toward the insulating layer (INS6) is defined in the pixel defining film (PDL),
wherein a tip part (TP), which exposes the groove (GV) and protrudes in a second direction toward the groove (GV), is defined on the inorganic layer (IOL),
wherein the second direction crosses the first direction.

13. The display device (DD) of any one of claims 1 to 11, further comprising a spacer (SC) disposed between the pixel defining film (PDL) and the inorganic layer (IOL) in the active area (DM-AA),
wherein a sub-groove (GV-S) convex in a first direction toward the pixel defining film (PDL) is defined in the spacer (SC),
wherein a tip part (TP), which exposes the sub-groove (GV-S) and protrudes in a second direction toward the sub-groove (GV-S), is defined on the inorganic layer (IOL),
wherein the second direction crosses the first direction.

14. An electronic apparatus (EA) comprising:
a display device (DD) in which a module area (DM-MH) is defined; and
an electronic module (ELM) disposed to correspond to the module area (DM-MH),
wherein the display device (DD) is the display device (DD) according to any one of claims 1 to 13.
